(19) **Europäisches Patentamt / European Patent Office / Office européen des brevets**

(11) **EP 3 373 345 B1**

(12) **FASCICULE DE BREVET EUROPEEN**

(45) Date de publication et mention
de la délivrance du brevet:
**15.09.2021 Bulletin 2021/37**

(51) Int Cl.:
***H01L 33/08*** (2010.01)     ***H01L 33/24*** (2010.01)
***H01L 33/44*** (2010.01)     ***H01L 33/56*** (2010.01)

(21) Numéro de dépôt: **18169640.2**

(22) Date de dépôt: **11.12.2014**

(54) **DISPOSITIF OPTOÉLECTRONIQUE À DIODES ÉLECTROLUMINESCENTES À EXTRACTION DE LUMIÈRE AMÉLIORÉE**

OPTOELEKTRONISCHE VORRICHTUNG MIT LEUCHTDIODEN MIT VERBESSERTER LICHTEXTRAKTION

OPTOELECTRONIC DEVICE COMPRISING LIGHT-EMITTING DIODES WITH IMPROVED LIGHT EXTRACTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2013 FR 1363005**

(43) Date de publication de la demande:
**12.09.2018 Bulletin 2018/37**

(62) Numéro(s) de document de la (des) demande(s) initiale(s) en application de l'article 76 CBE:
**14812451.4 / 3 084 846**

(73) Titulaires:
- **Aledia**
  **38130 Echirolles (FR)**
- **Commissariat à l'Energie Atomique et aux Energies Alternatives**
  **75015 Paris (FR)**

(72) Inventeurs:
- **DUPONT, Tiphaine**
  **38000 GRENOBLE (FR)**
- **DESIERES, Yohan**
  **38250 LANS EN VERCORS (FR)**

(74) Mandataire: **Cabinet Beaumont**
  **4, Place Robert Schuman**
  **B.P. 1529**
  **38025 Grenoble Cedex 1 (FR)**

(56) Documents cités:
  **US-A1- 2013 313 583**

- **JEN-HAU CHENG ET AL: "Atomic layer deposition enabled interconnect technology for vertical nanowire arrays", SENSORS AND ACTUATORS: A PHYSICAL ELSEVIER SEQUOIA S.A. SWITZERLAND, vol. 165, no. 1, janvier 2011 (2011-01), pages 107-114, XP002726521, ISSN: 0924-4247**

**Description**

La présente demande de brevet revendique la priorité de la demande de brevet français FR13/63005.

Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V.

L'efficacité d'extraction d'un dispositif optoélectronique est généralement définie par le rapport entre le nombre de photons qui s'échappent du dispositif optoélectronique et le nombre de photons émis par les diodes électroluminescentes. Il est souhaitable que l'efficacité d'extraction d'un dispositif optoélectronique soit la plus élevée possible.

Un inconvénient des dispositifs optoélectroniques existants est qu'une fraction des photons émis au sein de chaque diode électroluminescente ne s'échappe pas de la diode électroluminescente.

Un autre inconvénient des dispositifs optoélectroniques existants est qu'une partie de la lumière émise par chaque diode électroluminescente est piégée ou absorbée par les diodes électroluminescentes voisines. Le document US 2013/313583 décrit un dispositif d'émission de lumière à nanofils. La publication de Jen-Hau Cheng et al intitulée "Atomic layer déposition enabled interconnect technology for vertical nanowire arrays" (Sensors and Actuators A: Physical vol. 165, no. 1, janvier 2011, pages 107-114) décrit un dépôt de couche par un procédé de dépôt de couche mince atomique sur des nanofils.

Résumé

Ainsi, un objet d'un mode de réalisation est de pallier au moins en partie les inconvénients des dispositifs optoélectroniques à diodes électroluminescentes, notamment à microfils ou nanofils, décrits précédemment et de leurs procédés de fabrication.

Un autre objet d'un mode de réalisation est d'accroître l'efficacité d'extraction du dispositif optoélectronique.

Un autre objet d'un mode de réalisation est de réduire la proportion de la lumière qui ne s'échappe pas de chaque diode électroluminescente.

Un autre objet d'un mode de réalisation est de réduire la proportion de la lumière émise par une diode électroluminescente qui est absorbée/piégée par les diodes électroluminescentes voisines.

Un autre objet d'un mode de réalisation est que les dispositifs optoélectroniques à diodes électroluminescentes puissent être fabriqués à une échelle industrielle et à bas coût.

Ainsi, un mode de réalisation prévoit un dispositif optoélectronique selon la revendication 1 comprenant :

un substrat semiconducteur comprenant une face ;
des diodes électroluminescentes reposant sur la face et comprenant des éléments semiconducteurs filaires, coniques ou tronconiques ; et
une couche diélectrique au moins partiellement transparente recouvrant les diodes électroluminescentes, l'indice de réfraction de la couche diélectrique étant compris entre 1,6 et 1,8, l'épaisseur maximale de la première couche diélectrique étant comprise entre 250 nm et 50 $\mu$m, la première couche diélectrique recouvrant chaque élément semiconducteur.

Selon un mode de réalisation, l'indice de réfraction de la couche diélectrique est compris entre 1,7 et 1,75.

Selon un mode de réalisation, chaque élément semiconducteur est majoritairement en un composé III-V.

Selon un mode de réalisation, chaque élément semiconducteur comprend majoritairement du nitrure de gallium.

Selon un mode de réalisation, le diamètre moyen de chaque élément semiconducteur est compris entre 200 nm et 1 $\mu$m.

Selon un mode de réalisation, la couche d'encapsulation comprend une matrice en un premier matériau au moins partiellement transparent dans laquelle sont réparties des particules d'un deuxième matériau, l'indice de réfraction du deuxième matériau étant strictement supérieur à l'indice de réfraction du premier matériau.

Selon un mode de réalisation, le premier matériau est un polysiloxane.

Selon un mode de réalisation, le deuxième matériau est un matériau diélectrique choisi parmi l'oxyde de titane ($TiO_2$), l'oxyde de zirconium ($ZrO_2$) et le sulfure de zinc ($ZnS$).

Selon un mode de réalisation, la couche d'encapsulation est en un matériau choisi parmi le groupe comprenant les polymères époxydes, les oxydes de silicium du type $SiO_x$ où x est un nombre réel strictement supérieur à 0 et inférieur à 2, les oxydes de silicium du type $SiO_yN_z$, où y est un nombre réel strictement supérieur à 0 et inférieur ou égal à 2 et z est strictement supérieur à 0 et inférieur ou égal à 0,57, et l'oxyde d'aluminium ($Al_2O_3$).

Selon un mode de réalisation, les diodes électroluminescentes sont réparties sur une portion de la face et la densité surfacique de diodes électroluminescentes sur la portion décroît en s'éloignant des bords de ladite portion.

Selon un mode de réalisation, les diodes électroluminescentes sont réparties sur une portion de la face et le rapport entre le périmètre de ladite portion et la surface de ladite portion est supérieur ou égal à 4 pour une surface unitaire.

Selon un mode de réalisation, la portion correspond à une surface trouée.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe, partielle et schématique, d'un mode de réalisation d'un dispositif optoélectronique à microfils ou nanofils ;

les figures 2 à 6 illustrent différentes configurations de chemins suivis par des rayons lumineux dans des microfils ou nanofils ;

la figure 7 représente l'évolution de la répartition des modes de propagation de la lumière fournie par une diode électroluminescente à microfil ou nanofil en fonction de l'indice de réfraction du matériau entourant la diode électroluminescente ;

la figure 8 représente une courbe d'évolution du pourcentage de modes guidés piégés dans un microfil ou nanofil d'une diode électroluminescente en fonction de l'indice de réfraction du matériau entourant la diode électroluminescente ;

la figure 9 est une vue de dessus, partielle et schématique, d'un dispositif optoélectronique comprenant des diodes électroluminescentes à microfils ou nanofils ;

la figure 10 représente les variations de l'efficacité d'extraction selon la position considérée sur la face avant du dispositif optoélectronique de la figure 9 ; et

les figures 11 à 20 sont des vues de dessus, partielles et schématiques, de modes de réalisation de dispositifs optoélectroniques comprenant des diodes électroluminescentes à microfils ou nanofils.

Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de polarisation des diodes électroluminescentes d'un dispositif optoélectronique sont bien connus et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques à éléments tridimensionnels, par exemple des éléments filaires, coniques ou tronconiques, notamment des microfils ou des nanofils.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 $\mu$m, de préférence entre 50 nm et 2,5 $\mu$m, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 $\mu$m, de préférence comprises entre 100 nm et 1 $\mu$m, plus préférentiellement entre 100 nm et 800 nm. Dans certains modes de réalisation, la hauteur de chaque microfil ou nanofil peut être supérieure ou égale à 500 nm, de préférence comprise

entre 1 μm et 50 μm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

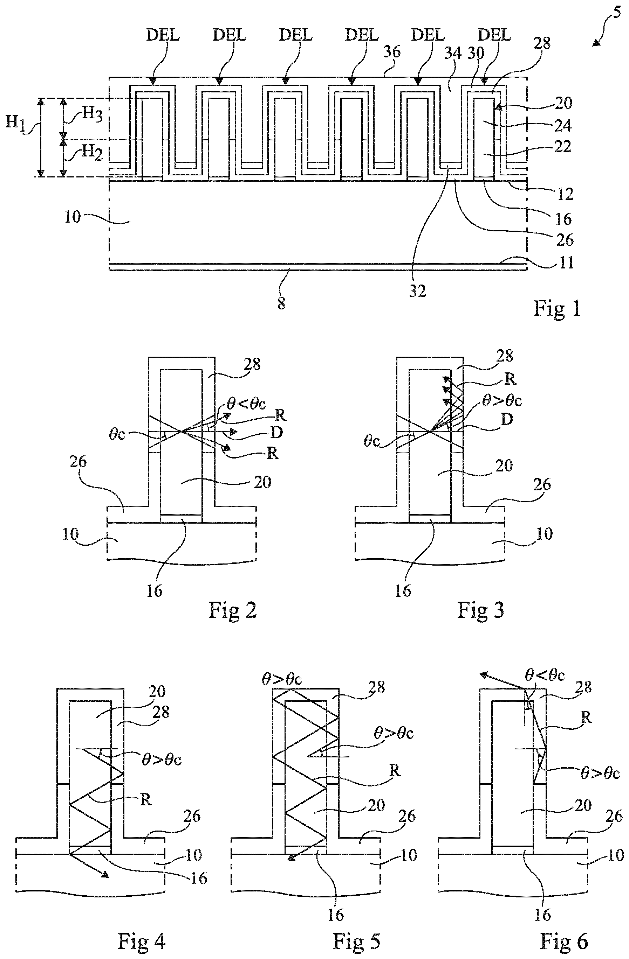

La figure 1 est une vue en coupe, partielle et schématique, d'un mode de réalisation d'un dispositif optoélectronique 5 à diodes électroluminescentes.

En figure 1, on a représenté une structure comprenant, du bas vers le haut :

une première électrode 8 ;
un substrat semiconducteur 10 comprenant une face inférieure 11 et une face supérieure 12, la face inférieure 11 étant recouverte de la première électrode 8 et la face supérieure 12 étant de préférence plane au moins au niveau des diodes électroluminescentes ;
des plots de germination 16 en un matériau conducteur favorisant la croissance de fils et disposés sur la face 12 ;
des fils 20 (six fils étant représentés) de hauteur $H_1$, chaque fil 20 étant en contact avec l'un des plots de germination 16, chaque fil 20 comprenant une portion inférieure 22, de hauteur $H_2$, en contact avec le plot de germination 16 et une portion supérieure 24, de hauteur $H_3$, prolongeant la portion inférieure 22 ;
une couche isolante 26 s'étendant sur la face 12 du substrat 10 et sur les flancs latéraux de la portion inférieure 22 de chaque fil 20 ;
une coque 28 comprenant un empilement de couches semiconductrices recouvrant chaque portion supérieure 24 ;
une couche 30 formant une deuxième électrode recouvrant chaque coque 28 et s'étendant, en outre, sur la couche isolante 26 ;
une couche conductrice miroir 32 recouvrant la couche d'électrode 30 entre les fils 20 mais ne s'étendant pas sur les fils 20 ; et
une couche d'encapsulation 34 recouvrant l'ensemble de la structure et notamment l'électrode 30 et comprenant une face avant 36.

Le dispositif optoélectronique 5 peut, en outre, comprendre une couche de luminophores, non représentée, prévue sur la couche d'encapsulation 34 ou confondue avec celle-ci.

L'ensemble formé par chaque fil 20, le plot de germination 16 et la coque 28 associés constitue une diode électroluminescente DEL. La base de la diode DEL correspond au plot de germination 16. La coque 28 comprend notamment une couche active qui est la couche depuis laquelle est émise la majorité du rayonnement électromagnétique fourni par la diode électroluminescente DEL. Les diodes électroluminescentes DEL peuvent être connectées en parallèle et former un ensemble de diodes électroluminescentes. L'ensemble peut comprendre de quelques diodes électroluminescentes DEL à un millier de diodes électroluminescentes.

Des diodes électroluminescentes DEL peuvent ne pas être formées sur la totalité de la face 12. On appelle zone active la partie de la face 12 sur laquelle des diodes électroluminescentes sont formées.

Le substrat 10 peut correspondre à une structure monobloc ou correspondre à une couche recouvrant un support constitué d'un autre matériau. Le substrat 10 est de préférence un substrat semiconducteur, par exemple un substrat en silicium, en germanium, en carbure de silicium, en un composé III-V, tel que du GaN ou du GaAs, ou un substrat en ZnO. De préférence, le substrat 10 est un substrat de silicium monocristallin. De préférence, il s'agit d'un substrat semiconducteur compatible avec les procédés de fabrication mis en oeuvre en microélectronique. Le substrat 10 peut correspondre à une structure multicouches de type silicium sur isolant, également appelée SOI (acronyme anglais pour Silicon On Insulator).

Le substrat peut être fortement dopé, faiblement dopé ou non dopé. Dans le cas où le substrat est fortement dopé, le substrat semiconducteur 10 peut être dopé de façon à baisser la résistivité électrique jusqu'à une résistivité proche de celle des métaux, de préférence inférieure à quelques mohm.cm. Le substrat 10 est, par exemple, un substrat fortement dopé avec une concentration de dopants comprise entre $5*10^{16}$ atomes/cm$^3$ et $2*10^{20}$ atomes/cm$^3$. Dans le cas où le substrat est faiblement dopé, par exemple avec une concentration de dopants inférieure ou égale à $5*10^{16}$ atomes/cm3, de préférence sensiblement égale à $10^{15}$ atomes/cm3, une région dopée du premier type de conductivité ou d'un deuxième type de conductivité, opposé au premier type, plus fortement dopée que le substrat peut être prévue qui s'étend dans le substrat 10 depuis la face 12 sous les plots de germination 16. Dans le cas d'un substrat 10 de silicium, des exemples de dopants de type P sont le bore (B) ou l'indium (In) et des exemples de dopants de type N sont le phosphore (P), l'arsenic (As), ou l'antimoine (Sb).

La face 12 du substrat 10 de silicium peut être une face (100) .

Les plots de germination 16, appelés également îlots de germination, sont en un matériau favorisant la croissance des fils 20. Un traitement peut être prévu pour protéger les flancs latéraux des plots de germination et la surface des parties du substrat non recouvertes par les plots de germination pour empêcher la croissance des fils sur les flancs latéraux des plots de germination et sur la surface des parties du substrat non recouvertes par les plots de germination.

Le traitement peut comprendre la formation d'une région diélectrique sur les flancs latéraux des plots de germination et s'étendant sur et/ou dans le substrat entre les plots, les fils ne croissant pas sur la région diélectrique. A titre de variante, les plots de germination 16 peuvent être remplacés par une couche de germination recouvrant la face 12 du substrat 10. Une région diélectrique peut alors être formée au-dessus de la couche de germination pour empêcher la croissance de fils dans les zones non voulues.

A titre d'exemple, le matériau composant les plots de germination 16 peut être un nitrure, un carbure ou un borure d'un métal de transition de la colonne IV, V ou VI du tableau périodique des éléments ou une combinaison de ces composés. A titre d'exemple, les plots de germination 16 peuvent être en nitrure d'aluminium (AlN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium ($ZrB_2$), en nitrure de zirconium (ZrN), en carbure de silicium (SiC), en nitrure et carbure de tantale (TaCN), en nitrure de magnésium sous la forme $Mg_xN_y$, où x est environ égal à 3 et y est environ égal à 2, par exemple du nitrure de magnésium selon la forme $Mg_3N_2$ ou du nitrure de gallium et de magnésium (MgGaN), en tungstène (W), en nitrure de tungstène (WN) ou en une combinaison de ceux-ci.

Les plots de germination 16 peuvent être dopés du même type de conductivité que le substrat 10.

La couche isolante 26 peut être en un matériau diélectrique, par exemple en oxyde de silicium ($SiO_2$), en nitrure de silicium ($Si_xN_y$, où x est environ égal à 3 et y est environ égal à 4, par exemple du $Si_3N_4$), en oxynitrure de silicium (notamment de formule générale $SiO_xN_y$, par exemple du $Si_2ON_2$), en oxyde d'aluminium ($Al_2O_3$), en oxyde d'hafnium ($HfO_2$) ou en diamant. A titre d'exemple, l'épaisseur de la couche isolante 26 est comprise entre 5 nm et 500 nm, par exemple égale à environ 30 nm.

Les fils 20 sont, au moins en partie, formés à partir d'au moins un matériau semiconducteur. Les fils 20 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 20 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 20 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. La hauteur $H_1$ de chaque fil 20 peut être comprise entre 250 nm et 50 $\mu m$. Chaque fil 20 peut avoir une structure semiconductrice allongée selon un axe sensiblement perpendiculaire à la face 12. Chaque fil 20 peut avoir une forme générale cylindrique. Les axes de deux fils 20 adjacents peuvent être distants de 0,5 $\mu m$ à 10 $\mu m$ et de préférence de 1,5 $\mu m$ à 6 $\mu m$. A titre d'exemple, les fils 20 peuvent être régulièrement répartis, notamment selon un réseau hexagonal.

A titre d'exemple, la portion inférieure 22 de chaque fil 20 est principalement constituée du composé III-N, par exemple du nitrure de gallium, dopé du même type que la région 14, par exemple de type N, par exemple au silicium. La portion inférieure 22 s'étend sur une hauteur $H_2$ qui peut être comprise entre 100 nm et 25 $\mu m$.

A titre d'exemple, la portion supérieure 24 de chaque fil 20 est au moins partiellement réalisée dans un composé III-N, par exemple du GaN. La portion supérieure 24 peut être dopée de type N, éventuellement moins fortement dopée que la portion inférieure 22, ou ne pas être intentionnellement dopée. La portion supérieure 24 s'étend sur une hauteur $H_3$ qui peut être comprise entre 100 nm et 25 $\mu m$.

La coque 28 peut comprendre un empilement de plusieurs couches comprenant notamment :

- une couche active recouvrant la portion supérieure 24 du fil 20 associé ;
- une couche intermédiaire de type de conductivité opposé à la portion inférieure 22 recouvrant la couche active ; et
- une couche de liaison recouvrant la couche intermédiaire et recouverte par l'électrode 30.

La couche active est la couche depuis laquelle est émise la majorité du rayonnement fourni par la diode électroluminescente DEL. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure 24 de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30. A titre d'exemple, la couche de liaison peut être dopée très fortement du type opposé à la portion inférieure 22 de chaque fil 20, jusqu'à dégénérer la ou les couches semiconductrices, par exemple dopée de type P à une concentration supérieure ou égale à $10^{20}$ atomes/cm$^3$.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 30 est adaptée à polariser la couche active de chaque fil 20 et à laisser passer le rayonnement électromagnétique émis par les diodes électroluminescentes DEL. Le matériau formant l'électrode 30 peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 30 a une épaisseur comprise entre 5 nm et 200 nm, de préférence entre 20 nm et 50 nm.

La couche conductrice miroir 32 correspond, de préférence à une couche métallique, par exemple en aluminium, en argent, en cuivre ou en zinc. A titre d'exemple, la couche conductrice miroir 32 a une épaisseur comprise entre 20 nm et 300 nm, de préférence entre 100 nm et 200 nm.

La couche d'encapsulation 34 est réalisée en un matériau isolant au moins partiellement transparent. L'épaisseur maximale de la couche d'encapsulation 34 est supérieure à la hauteur $H_1$ des fils 20. La couche d'encapsulation 34 s'étend entre les fils 20 et recouvre chaque fil 20. L'espace entre les fils 20 est complètement rempli par la couche d'encapsulation 34. L'épaisseur maximale de la couche d'encapsulation 34 est comprise entre 250 nm et 50 μm de sorte que la couche d'encapsulation 34 recouvre complètement l'électrode 30 au sommet des diodes électroluminescentes DEL.

La couche active de la coque 28 de chaque diode électroluminescente DEL émet de la lumière dans toutes les directions.

Les figures 2 à 6 illustrent les chemins parcourus par des rayons lumineux R pour différentes configurations d'émission de lumière. Sur les figures 2 à 6, les couches 30, 32 et 34 n'ont pas été représentées. On appelle θ l'angle que forme le rayon lumineux R par rapport à la direction perpendiculaire D aux parois latérales du fil 20 et $θ_C$ l'angle critique de réflexion totale de l'ensemble comprenant le fil 20 et la couche active de la coque 28.

Selon l'angle d'émission θ, la lumière émise par la couche active de la coque 28 peut soit se coupler à un mode rayonné appelé RL, comme cela est illustré en figure 2, soit à un mode guidé appelé GL, comme cela est illustré en figure 3. Les modes guidés GL ont un angle d'émission θ supérieur à l'angle critique de réflexion totale $θ_C$ et se propagent en zigzagant le long du fil 20. A l'inverse, les modes rayonnés RL ont un angle d'émission θ inférieur à l'angle critique de réflexion totale $θ_C$ et sont entièrement transmis dans la couche d'encapsulation 34.

L'angle critique de réflexion totale $θ_C$ est donné par la loi de Snell selon la relation (1) suivante :

$$θ_C = \mathrm{asin}(n_{encap}/n_{fil}) \qquad\qquad (1)$$

où $n_{encap}$ est la partie réelle de l'indice de réfraction optique de la couche d'encapsulation 34 et $n_{fil}$ est la partie réelle de l'indice de réfraction optique du fil 20 et de sa coque 28, $n_{fil}$ étant strictement supérieur à $n_{encap}$.

L'indice de réfraction optique est un nombre sans dimension qui caractérise les propriétés optiques d'un milieu, notamment l'absorption et la diffusion. L'indice de réfraction est égal à la partie réelle de l'indice optique complexe. L'indice de réfraction peut être déterminé, par exemple, par ellipsométrie.

Selon l'angle d'incidence θ, les modes guidés GL se décomposent en modes perdus dans le substrat SGL (figure 4), en modes réfléchis RGL (figure 5) et transmis TGL (figure 6). Les modes SGL sont guidés vers le pied du fil 20 et perdus dans le substrat 10. Les modes TGL ont un angle d'incidence à la facette supérieure du fil 20 qui est inférieur à l'angle critique de réflexion totale et sont donc transmis dans la couche d'encapsulation 34. Les modes RGL sont en condition de réflexion totale à la facette supérieure et sont renvoyés vers le pied du fil 20 sans être extraits.

Parmi les modes guidés GL, seuls les modes guidés transmis TGL participent à la lumière perçue par un observateur. Les modes guidés vers le substrat SGL sont directement perdus et les modes réfléchis RGL restent piégés à l'intérieur du fil 20 jusqu'à être absorbés ou être perdus dans le substrat 10.

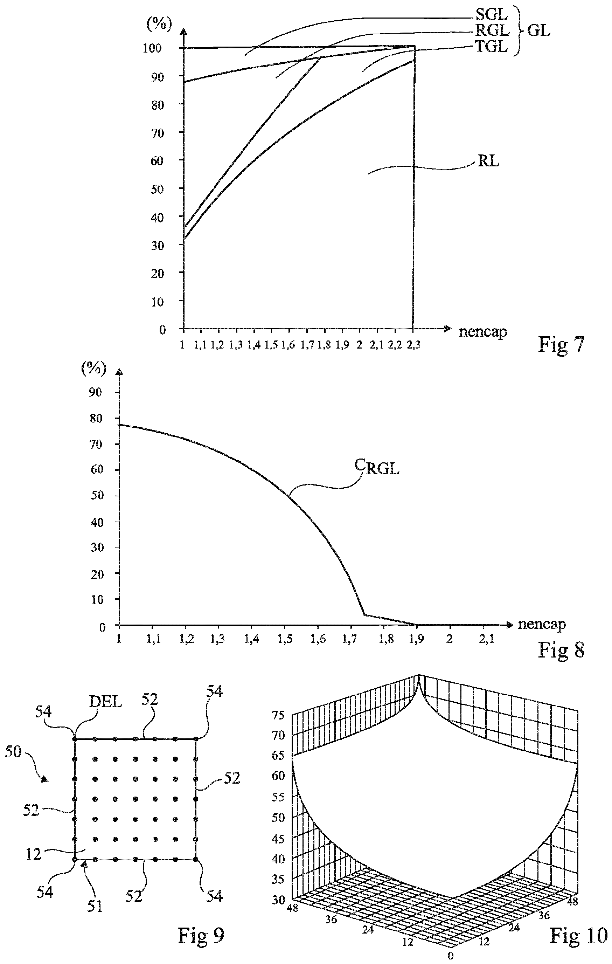

La figure 7 représente la part de modes RL, GL, SGL, RGL et TGL en fonction de l'indice de réfraction $n_{encap}$ de la couche d'encapsulation 34. La part de lumière extraite de la diode électroluminescente est la somme des parts RL et TGL.

La figure 8 représente une courbe d'évolution $C_{RGL}$ correspondant à la part de modes guidés RGL sur le nombre total de modes guidés GL en fonction de l'indice de réfraction $n_{encap}$ de la couche d'encapsulation 34. Les courbes des figures 7 et 8 ont été obtenues dans le cas d'un fil de GaN de section hexagonale ayant un diamètre moyen de 800 nm et une coque de 275 nm d'épaisseur.

La proportion de modes rayonnés, RL, augmente tandis que la proportion de modes guidés, GL, diminue lorsque l'indice de réfraction de la couche d'encapsulation 34 augmente. En outre, la proportion de lumière guidée piégée RGL diminue jusqu'à s'annuler pour un indice de réfraction de la couche d'encapsulation 34 égal à environ 1,73.

Par simulation, les inventeurs ont mis en évidence que l'allure des courbes d'évolution des proportions de modes RL, GL, SGL, RGL et TGL est sensiblement la même indépendamment du diamètre moyen du fil 20, dès que le diamètre moyen du fil 20 est supérieur à 200 nm. En particulier, l'indice de réfraction auquel le mode de propagation RGL s'annule est sensiblement indépendant du diamètre moyen du fil 20, dès que le diamètre moyen du fil 20 est supérieur à 200 nm.

Pour être perçue par un observateur regardant le dispositif optoélectronique 5, la lumière doit quitter la couche d'encapsulation par la face avant 36. La face 36 peut correspondre à une surface libre, c'est-à-dire en contact avec de l'air. Plus la différence entre l'indice de réfraction de la couche d'encapsulation 34 et l'indice de l'air est importante, plus l'angle critique de réflexion totale, mesuré par rapport à une direction perpendiculaire à la face 36, est faible, c'est-à-dire plus la lumière provenant des diodes électroluminescentes DEL tend à se réfléchir sur la face 36. Il n'est donc pas souhaitable que l'indice de réfraction de la couche d'encapsulation 34 soit trop élevé.

Lorsque le matériau composant les fils et les couches actives est un composé III-V, les inventeurs ont mis en évidence par simulation que le meilleur compromis était obtenu avec un indice de réfraction de la couche d'encapsulation 34 compris entre 1,7 et 1,75, de préférence compris entre 1,72 et 1,74, plus préférentiellement d'environ 1,73.

De préférence, le diamètre moyen du fil 20 est compris entre 200 nm et 1 μm, de préférence entre 300 nm et 800 nm.

La couche d'encapsulation 34 peut comprendre une matrice d'un matériau inorganique au moins partiellement transparent dans laquelle sont éventuellement réparties des particules d'un matériau diélectrique. L'indice de réfraction du matériau diélectrique composant les particules est strictement supérieur à l'indice de réfraction du matériau composant la matrice. Selon un exemple, la couche d'encapsulation 34 comprend une matrice en silicone, également appelée polysiloxane, et comprend, en outre, des particules d'un matériau diélectrique réparties dans la matrice. Les particules sont en tout type de matériau permettant l'obtention de particules de dimensions nanométriques relativement sphériques et ayant un indice de réfraction adapté. A titre d'exemple, les particules peuvent être en oxyde de titane ($TiO_2$), en oxyde de zirconium ($ZrO_2$), en sulfure de zinc (ZnS), en sulfure de plomb (PbS) ou en silicium amorphe (Si). On appelle diamètre moyen d'une particule le diamètre de la sphère de même volume. Le diamètre moyen des particules du matériau diélectrique est compris entre 2 nm et 250 nm. La concentration en volume des particules par rapport au poids total de la couche d'encapsulation 34 est comprise entre 1 % et 50 %.

Selon un autre exemple, le matériau inorganique est choisi parmi le groupe comprenant les oxydes de silicium du type $SiO_x$ où x est un nombre réel strictement supérieur à 0 et inférieur à 2, les oxydes de silicium du type $SiO_yN_z$ où y est un nombre réel strictement supérieur à 0 et inférieur ou égal à 2 et z est strictement supérieur 0 et inférieur ou égal à 0,57, et l'oxyde d'aluminium ($Al_2O_3$).

La couche d'encapsulation 34 peut être réalisée en un matériau organique au moins partiellement transparent. Selon un exemple, la couche d'encapsulation 34 est en polyimide. Selon un autre exemple, la couche d'encapsulation 34 est en un polymère époxyde qui comprend, en outre, des particules d'un matériau diélectrique réparties dans la matrice. Les particules peuvent être en oxyde de titane ($TiO_2$), en oxyde de zirconium ($ZrO_2$), en sulfure de zinc (ZnS), en sulfure de plomb (PbS) ou en silicium amorphe (Si).

Pour améliorer l'efficacité d'extraction du dispositif optoélectronique 5, un traitement de surface, appelé texturation, peut être appliqué à la face 36 de la couche d'encapsulation 34 de façon à former des reliefs sur la face 36. Pour une couche d'encapsulation 34 constituée d'un matériau inorganique, le procédé de texturation de la face 36 peut comprendre une étape de gravure chimique ou une étape d'abrasion mécanique, éventuellement en présence d'un masque protégeant des parties de la face 36 traitées pour favoriser la formation de motifs en surface. Pour une couche 34 constituée d'un matériau organique, le procédé de texturation de la face 36 peut comprendre une étape d'estampage, de moulage, etc.

Pour améliorer l'efficacité d'extraction du dispositif optoélectronique 5, la couche d'encapsulation 34 peut être recouverte d'une couche supplémentaire au moins partiellement transparente. L'indice de réfraction de la couche supplémentaire se situe alors entre l'indice de réfraction de la couche d'encapsulation 34 et l'indice de réfraction de l'air. A titre de variante, un empilement d'au moins deux couches peut recouvrir la couche d'encapsulation 34. Les indices de réfraction des couches de l'empilement sont décroissants depuis la première couche de l'empilement en contact avec la couche d'encapsulation 34 jusqu'à la dernière couche de l'empilement en contact avec l'air, l'indice de réfraction de la première couche étant strictement inférieur à l'indice de réfraction de la couche d'encapsulation 34 et l'indice de réfraction de la dernière couche étant strictement supérieur à l'indice de réfraction de l'air.

Le dispositif optoélectronique selon le mode de réalisation décrit précédemment permet de façon avantageuse d'augmenter l'efficacité d'extraction globale du dispositif optoélectronique, c'est-à-dire mesurée sur la totalité de la face 36.

L'efficacité d'extraction peut être mesurée localement, c'est-à-dire pour une portion de la face 36. Elle correspond alors au rapport entre la quantité de lumière qui s'échappe du dispositif optoélectronique par la portion considérée et la quantité de lumière fournie par les diodes électroluminescentes de cette portion. Il est souhaitable que les variations de l'efficacité d'extraction locale sur l'ensemble de la face 36 soient les plus faibles possibles pour éviter qu'un observateur ne perçoive des différences de luminance en regardant le dispositif optoélectronique 5.

La figure 9 est une vue de dessus d'un exemple de dispositif optoélectronique 50, comprenant l'ensemble des éléments du dispositif optoélectronique 5 représenté en figure 1 et dans lequel les diodes électroluminescentes DEL sont réparties de façon régulière, par exemple en rangées et en colonnes, sur une zone active 51 carrée. Les bords latéraux de la zone active 51 sont désignés par la référence 52 et les coins de la zone active 51 sont désignés par la référence 54. Chaque diode électroluminescente est représentée, de façon schématique, par un point. A titre d'exemple, à l'exception des diodes situées le long des bords 52, chaque diode électroluminescente DEL est située au centre d'un carré comprenant une diode électroluminescente à chaque sommet et une diode électroluminescente au milieu de chaque arête.

Dans l'exemple représenté en figure 9, la densité de diodes électroluminescentes par unité de surface est sensiblement constante sur toute la zone active 51. A titre d'exemple, la densité surfacique de diodes électroluminescentes est sensiblement constante et comprise entre $4*10^6/cm^2$ et $3*10^7/cm^2$.

La figure 10 représente l'évolution de l'efficacité d'extraction locale du dispositif optoélectronique 50 de la figure 9 sur un quart de la zone active 51. La courbe de la figure 10 a été obtenue dans le cas d'une matrice de nanofils GaN de section hexagonale, la distance entre les axes de deux nanofils étant de 3 fois le rayon moyen de la coque 28 et l'indice de réfraction du matériau de l'encapsulant 34 étant égal à 1,75.

L'efficacité d'extraction locale est supérieure le long des bords 52 par rapport au centre de la zone active 51. En outre, l'efficacité d'extraction locale est supérieure aux sommets 54 par rapport aux bords 52 de la zone active 51. L'explication de ce phénomène est que plus le nombre de voisins proches d'une diode électroluminescente est important, plus la probabilité est élevée que les rayons lumineux émis par cette diode électroluminescente rencontrent l'une des diodes électroluminescentes voisines et ne soient absorbés ou piégés par celles-ci.

Par simulation, les inventeurs ont mis en évidence une diminution de l'efficacité d'extraction dès que la distance entre les axes de deux diodes électroluminescentes adjacentes est inférieure à 15 fois le rayon moyen de la coque 28.

Pour des distances entre les axes de diodes électroluminescentes adjacentes inférieures à 15 fois le rayon moyen de la coque 28, il a été observé que l'efficacité d'extraction du centre de la zone active 51 atteint un minimum dont la valeur est indépendante du nombre de rangées et colonnes lorsque le nombre de rangées et colonnes est supérieur à environ 50.

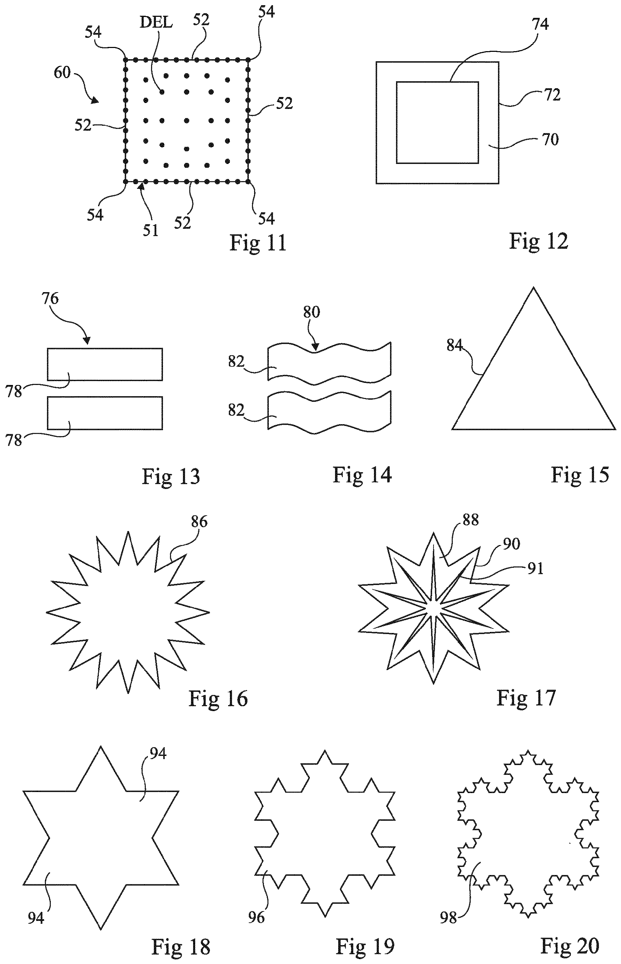

La figure 11 est une vue analogue à la figure 9 d'un mode de réalisation d'un dispositif optoélectronique 60. Le dispositif optoélectronique 60 comprend tous les éléments du dispositif optoélectronique 50 à la différence que la densité de diodes électroluminescentes par unité de surface augmente graduellement du centre du dispositif jusqu'aux bords 52. Plus précisément, la densité surfacique de diodes électroluminescentes au centre de la zone active 51 est strictement inférieure à la densité surfacique de diodes électroluminescentes le long des bords 52. En outre, la densité surfacique de diodes électroluminescentes le long des bords 52 est strictement inférieure à la densité surfacique de diodes électroluminescentes aux sommets 54 de la zone active 51.

A titre d'exemple, l'évolution de la densité surfacique de diodes électroluminescentes peut correspondre à l'inverse de l'évolution de l'efficacité d'extraction telle que représentée en figure 10. A titre d'exemple, la densité surfacique de diodes électroluminescentes au centre de la zone active du dispositif optoélectronique peut être comprise entre $2*10^6/cm^2$ et $6*10^6/cm^2$ tandis que la densité surfacique de diodes électroluminescentes le long d'un bord de la zone active du dispositif optoélectronique peut être comprise entre $7*10^6/cm^2$ et $2*10^7/cm^2$.

Selon un autre mode de réalisation, les inventeurs ont mis en évidence que l'uniformité de l'efficacité d'extraction pouvait être améliorée en augmentant le rapport entre le périmètre de la zone active et la surface de la zone active. De préférence, le rapport P/A entre le périmètre et la surface de la zone active est supérieur à 4 pour une surface de zone active unitaire, de préférence supérieur ou égal à 4,5, plus préférentiellement supérieur ou égal à 5, notamment supérieur ou égal à 6.

Les figures 12 à 20 représentent des vues de dessus schématiques de modes de réalisation de dispositifs optoélectroniques pour chacun desquels seul le contour de la zone active a été représenté. Pour chacun de ces exemples, le rapport entre le périmètre de la zone active et la surface de la zone active est strictement supérieur à celui obtenu pour un carré de même surface.

En figure 12, la zone active 70 a une forme annulaire comprenant un bord externe carré 72 et un bord interne carré 74. En figure 13, la zone active 76 comprend une ou plus d'une zone rectangulaire 78, deux zones rectangulaires étant représentées. En figure 14, la zone active 80 comprend une ou plus d'une bande 82 à bords ondulés, deux bandes 82 étant représentées. En figure 15, la zone active 84 a une forme triangulaire. En figure 16, la zone active 86 a une forme d'étoile. En figure 17, la zone active 88 comprend un bord extérieur 90 en forme d'étoile et un bord intérieur 91 en forme d'étoile. De façon avantageuse, le périmètre extérieur, et éventuellement intérieur, de la zone active suit une courbe qui se rapproche d'une courbe fractale. Sur les figures 18, 19 et 20, les zones actives 94, 96 et 98 ont respectivement la forme d'un flocon de Koch après deux, trois et quatre itérations. Le rapport P/A pour une surface de zone active unitaire est respectivement de 6,4, 8,5 et 11,4 pour les zones actives 94, 96 et 98. Les figures 12 et 17 représentent des exemples de zones actives correspondant à des surfaces trouées.

Un mode de réalisation d'un procédé de fabrication permettant l'obtention du dispositif optoélectronique 5 comprend les étapes suivantes :

(1) Formation sur la face 12 du substrat 10 des plots de germination 16.

Les plots de germination 16 peuvent être obtenus par le dépôt d'une couche de germination sur la face 12 et par la gravure de portions de la couche de germination jusqu'à la face 12 du substrat 10 pour délimiter les plots de germination. La couche de germination peut être déposée par un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés tels que l'évaporation ou la pulvérisation cathodique réactive peuvent être utilisés.

Lorsque les plots de germination 16 sont en nitrure d'aluminium, ils peuvent être sensiblement texturés et posséder une polarité préférentielle. La texturation des plots 16 peut être obtenue par un traitement supplémentaire réalisé après le dépôt de la couche de germination. Il s'agit, par exemple, d'un recuit sous flux d'ammoniac (NH$_3$).

(2) Protection des portions de la face 12 du substrat 10 non recouvertes des plots de germination 16 pour éviter la croissance ultérieure de fils sur ces portions. Ceci peut être obtenu par une étape de nitruration qui entraîne la formation, en surface du substrat 10, entre les plots de germination 16 de régions de nitrure de silicium (par exemple SiN ou Si$_3$N$_4$). Ceci peut également être obtenu par une étape de masquage du substrat 10 entre les plots de germination 16, incluant le dépôt d'une couche par exemple d'un diélectrique SiO$_2$ ou SiN ou Si$_3$N$_4$ puis la gravure de cette couche hors des plots de germination 16 après une étape de photolithographie. Dans ce cas, la couche de masquage peut déborder au-dessus des plots de germination 16. Lorsque l'étape de protection (2) est réalisée par une étape de masquage du substrat 10, l'étape de gravure de la couche de germination peut être évitée. Les plots de germination 16 sont alors constitués d'une couche continue uniforme et dont la surface est laissée libre au niveau où les fils croissent.

(3) Croissance de la portion inférieure 22 de chaque fil 20 sur la hauteur H$_2$. Chaque fil 20 croît depuis le sommet du plot de germination 16 sous-jacent.

Le procédé de croissance des fils 20 peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de croissance des fils peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH$_3$), le tertiarybutylphosphine (TBP), l'arsine (AsH$_3$), ou le diméthylhydrazine asymétrique (UDMH).

Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH$_4$).

La présence de silane parmi les gaz précurseurs entraîne l'incorporation de silicium au sein du composé GaN. On obtient ainsi une portion inférieure 22 dopée de type N. En outre, ceci se traduit par la formation d'une couche de nitrure de silicium, non représentée, qui recouvre le pourtour de la portion 22 de hauteur H$_2$, à l'exception du sommet au fur et à mesure de la croissance de la portion 22.

(4) Croissance de la portion supérieure 24 de hauteur H$_3$ de chaque fil 20 sur le sommet de la portion inférieure 22. Pour la croissance de la portion supérieure 24, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure 24 peut être dopée de type N en raison de la diffusion dans cette portion active de dopants provenant des portions passivées adjacentes ou en raison du dopage résiduel du GaN.

(5) Formation de la couche isolante 26, par exemple par dépôt conforme d'une couche isolante sur la totalité de la structure obtenue à l'étape (4) et gravure de cette couche pour exposer la portion supérieure 24 de chaque fil 20.

(6) Formation par épitaxie, pour chaque fil 20, des couches composant la coque 28. Compte tenu de la présence de la couche isolante 26 recouvrant le pourtour de la portion inférieure 22, le dépôt des couches composant la coque 28 ne se produit que sur la portion supérieure 24 du fil 20 non recouverte par la couche isolante 26 ;

(7) Formation de l'électrode 30, par exemple par dépôt conforme ;

(8) Formation de la couche conductrice miroir 32 par exemple par dépôt physique en phase vapeur (PVD, acronyme anglais pour Physical Vapor Déposition) sur l'ensemble de la structure obtenue à l'étape (7) ou par exemple par évaporation ou par pulvérisation cathodique et gravure de cette couche pour exposer chaque fil 20 ;

(9) Formation de la couche d'encapsulation 34. Lorsque la couche d'encapsulation 34 est en silicone, la couche d'encapsulation 34 peut être déposée par un procédé de dépôt à la tournette, par un procédé d'impression par jet ou par un procédé de sérigraphie. Lorsque la couche d'encapsulation 34 est un oxyde, elle peut être déposée par CVD ; et

(10) Découpe du substrat 10 pour séparer les dispositifs optoélectroniques.

Dans le mode de réalisation décrit précédemment, la couche isolante 26 recouvre la totalité du pourtour de la portion inférieure 22 de chaque fil 20. A titre de variante, une partie de la portion inférieure 22 peut ne pas être recouverte par la couche isolante 26. Dans ce cas, la couche isolante 26 recouvre le fil 20 sur une hauteur inférieure à $H_2$ et la coque 28 recouvre le fil 20 sur une hauteur supérieure à $H_3$. La couche 26 peut ne pas recouvrir la portion inférieure 22 de chaque fil 20. Dans ce cas, la coque 28 peut recouvrir chaque fil 20 sur la hauteur $H_1$.

Dans le mode de réalisation décrit précédemment, la couche isolante 26 ne recouvre pas le pourtour de la portion supérieure 24 de chaque fil 20. A titre de variante, la couche isolante 26 peut recouvrir une partie de la portion supérieure 24 de chaque fil 20. Dans ce cas, la couche isolante 26 recouvre le fil 20 sur une hauteur supérieure à $H_2$ et la coque 28 recouvre le fil 20 sur une hauteur inférieure à $H_3$.

Selon une autre variante, la couche isolante 26 peut, pour chaque fil 20, recouvrir partiellement la portion inférieure de la coque 30.

Selon une variante du procédé de fabrication décrit précédemment, les couches composant la coque 28 peuvent être formées avant la couche isolante 26 sur la totalité de chaque fil 20 ou seulement sur une partie du fil 20, par exemple la partie supérieure 24.

Des modes de réalisation particuliers de la présente invention ont été décrits. Diverses variantes et modifications apparaîtront à l'homme de l'art. De plus, bien que, dans les modes de réalisation décrits précédemment, chaque fil 20 comprenne une portion passivée 22, à la base du fil en contact avec l'un des plots de germination 16, cette portion passivée 22 peut ne pas être présente.

En outre, bien que des modes de réalisation aient été décrits pour un dispositif optoélectronique pour lequel la coque 28 recouvre le sommet du fil 20 associé et une partie des flancs latéraux du fil 20, la coque peut n'être prévue qu'au sommet du fil 20.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, le dispositif optoélectronique comprenant une couche d'encapsulation ayant un indice de réfraction compris entre 1,7 et 1,75 peut, en outre, comprendre une densité surfacique des diodes électroluminescentes qui est variable, par exemple comme cela est représenté en figure 11. En outre, le dispositif optoélectronique comprenant une couche d'encapsulation ayant un indice de réfraction compris entre 1,7 et 1,75 peut, en outre, avoir un rapport entre le périmètre et la surface de la zone active qui est strictement supérieur au rapport obtenu pour une zone active carrée, par exemple comme cela a été décrit précédemment en relation avec les figures 12 à 20. De plus, le dispositif optoélectronique ayant un rapport entre le périmètre et la surface de la zone active qui est strictement supérieur au rapport obtenu pour une zone active carrée, peut en outre comprendre une densité surfacique des diodes électroluminescentes qui est variable.

**Revendications**

1. Dispositif optoélectronique (5) comprenant :

    un substrat (10) semiconducteur comprenant une face (12) ;
    des diodes électroluminescentes (DEL) reposant sur la face et comprenant des éléments semiconducteurs (20) filaires, coniques ou tronconiques, chaque élément semiconducteur (20) étant majoritairement en un composé III-V ; et

une première couche diélectrique (34) au moins partiellement transparente recouvrant les diodes électroluminescentes, **caractérisé en ce que** l'indice de réfraction de la première couche diélectrique est compris entre 1,6 et 1,8, et l'épaisseur maximale de la première couche diélectrique (34) est comprise entre 250 nm et 50 $\mu$m, la première couche diélectrique recouvrant chaque élément semiconducteur.

2. Dispositif optoélectronique selon la revendication 1, dans lequel la première couche diélectrique (34) est un oxyde formé par dépôt chimique en phase vapeur.

3. Dispositif optoélectronique selon la revendication 1 ou 2, dans lequel l'indice de réfraction de la première couche diélectrique (34) est compris entre 1,7 et 1,75.

4. Dispositif optoélectronique selon l'une quelconque des revendications 1 à 3, dans lequel chaque élément semiconducteur (20) comprend majoritairement du nitrure de gallium.

5. Dispositif optoélectronique selon l'une quelconque des revendications 1 à 4, dans lequel le diamètre moyen de chaque élément semiconducteur (20) est compris entre 200 nm et 1 $\mu$m.

6. Dispositif optoélectronique selon l'une quelconque des revendications 1 à 5, dans lequel la première couche diélectrique (34) comprend une matrice en un premier matériau au moins partiellement transparent dans laquelle sont réparties des particules d'un deuxième matériau, l'indice de réfraction du deuxième matériau étant strictement supérieur à l'indice de réfraction du premier matériau.

7. Dispositif optoélectronique selon la revendication 6, dans lequel le premier matériau est un polysiloxane.

8. Dispositif optoélectronique selon la revendication 6 ou 7, dans lequel le deuxième matériau est un matériau diélectrique choisi parmi l'oxyde de titane ($TiO_2$), l'oxyde de zirconium ($ZrO_2$) et le sulfure de zinc ($ZnS$).

9. Dispositif optoélectronique selon l'une quelconque des revendications 1 à 8, comprenant une deuxième couche au moins partiellement transparente recouvrant la première couche (34).

10. Dispositif optoélectronique selon la revendication 9, comprenant un empilement comprenant une troisième couche au moins partiellement transparente et la deuxième couche, ledit empilement recouvrant la première couche (34).

11. Dispositif optoélectronique selon l'une quelconque des revendications 1 à 10, dans lequel la première couche diélectrique (34) est en un matériau choisi parmi le groupe comprenant les polymères époxydes, les oxydes de silicium du type $SiO_x$ où x est un nombre réel strictement supérieur à 0 et inférieur à 2, les oxydes de silicium du type $SiO_yN_z$, où y est un nombre réel compris strictement supérieur à 0 et inférieur ou égal à 2 et z est strictement supérieur à 0 et inférieur ou égal à 0,57, et l'oxyde d'aluminium ($Al_2O_3$).

12. Dispositif optoélectronique selon l'une quelconque des revendications 1 à 11, dans lequel les diodes électroluminescentes (DEL) sont réparties sur une portion (51) de la face (12) et la densité surfacique de diodes électroluminescentes (DEL) sur la portion décroît en s'éloignant des bords (52) de ladite portion.

13. Dispositif optoélectronique selon l'une quelconque des revendications 1 à 12, dans lequel les diodes électroluminescentes (DEL) sont réparties sur une portion (70 ; 76 ; 80 ; 84 ; 86 ; 88 ; 94 ; 96 ; 98) de la face (12) et dans lequel le rapport entre le périmètre de ladite portion et la surface de ladite portion est supérieur ou égal à 4 pour une surface unitaire.

**Patentansprüche**

1. Eine optoelektronische Vorrichtung (5), die Folgendes aufweist:

ein Halbleitersubstrat (10) mit einer Oberfläche (12);
lichtemittierende Dioden (DEL), die von der Oberfläche getragen werden und drahtförmige, konische oder kegelstumpfförmige Halbleiterelemente (20) aufweisen, wobei jedes Halbleiterelement (20) hauptsächlich aus einer III-V-Verbindung hergestellt ist; und

eine zumindest teilweise transparente erste dielektrische Schicht (34), die die lichtemittierenden Dioden bedeckt, **dadurch gekennzeichnet, dass**

der Brechungsindex der ersten dielektrischen Schicht im Bereich von 1,6 bis 1,8 liegt und die maximale Dicke der ersten dielektrischen Schicht im Bereich von 250 nm bis 50 $\mu$m liegt, wobei die erste dielektrische Schicht jedes Halbleiterelement bedeckt.

2. Optoelektronische Vorrichtung nach Anspruch 1, wobei die erste dielektrische Schicht (34) ein Oxid ist, das durch physikalische Abscheidung aus der Dampfphase gebildet wird.

3. Optoelektronische Vorrichtung nach Anspruch 1 oder 2, wobei der Brechungsindex der ersten dielektrischen Schicht (34) im Bereich von 1,7 bis 1,75 liegt.

4. Optoelektronische Vorrichtung nach einem der Ansprüche 1 bis 3, wobei jedes Halbleiterelement (20) hauptsächlich Galliumnitrid aufweist.

5. Optoelektronische Vorrichtung nach einem der Ansprüche 1 bis 4, wobei der mittlere Durchmesser jedes Halbleiterelements (20) im Bereich von 200 nm bis 1 $\mu$m liegt.

6. Optoelektronische Vorrichtung nach einem der Ansprüche 1 bis 5, wobei die erste dielektrische Schicht (34) eine Matrix aus einem ersten, zumindest teilweise transparenten Material mit darin verteilten Partikeln eines zweiten Materials aufweist, wobei der Brechungsindex des zweiten Materials größer ist als der Brechungsindex des ersten Materials.

7. Optoelektronische Vorrichtung nach Anspruch 6, wobei das erste Material ein Polysiloxan ist.

8. Optoelektronische Vorrichtung nach Anspruch 6 oder 7, wobei das zweite Material ein dielektrisches Material ist, das aus Titanoxid ($TiO_2$), Zirkoniumoxid ($ZrO_2$) und Zinksulfid (ZnS) ausgewählt ist.

9. Optoelektronische Vorrichtung nach einem der Ansprüche 1 bis 8, die eine zumindest teilweise transparente zweite Schicht aufweist, die die erste Schicht (84) bedeckt.

10. Optoelektronische Vorrichtung nach Anspruch 9, der einen Stapel aufweist, die eine zumindest teilweise transparente dritte Schicht und die zweite Schicht aufweist, wobei der Stapel die erste Schicht (84) bedeckt.

11. Optoelektronische Vorrichtung nach einem der Ansprüche 1 bis 10, wobei die erste dielektrische Schicht (34) aus einem Material besteht, das aus der Gruppe ausgewählt ist, die Epoxidpolymere, Siliziumoxide vom $SiO_x$-Typ, wobei x eine reelle Zahl größer als 0 und kleiner als 2 ist, Siliziumoxide vom $SiO_yN_z$-Typ, wobei y eine reelle Zahl größer als 0 und kleiner als oder gleich 2 ist und z größer als 0 und kleiner als oder gleich 0,57 ist, und Aluminiumoxid ($Al_2O_3$) aufweist.

12. Optoelektronische Vorrichtung nach einem der Ansprüche 1 bis 11, wobei die lichtemittierenden Dioden (DEL) über einen Teil (51) der Oberfläche (12) verteilt sind und die Oberflächendichte der lichtemittierenden Dioden (DEL) auf dem Teil von den Rändern (52) des genannten Teils weg abnimmt.

13. Optoelektronische Vorrichtung nach einem der Ansprüche 1 bis 12, wobei die lichtemittierenden Dioden (DEL) über einen Abschnitt (70; 76; 80; 84; 86; 88; 94; 96; 98) der Oberfläche (12) verteilt sind und wobei das Verhältnis des Umfangs des Abschnitts zur Oberfläche des Abschnitts größer als oder gleich 4 für eine Oberflächeneinheit ist.

**Claims**

1. An optoelectronic device (5) comprising:

a semiconductor substrate (10) having a surface (12);
light-emitting diodes (DEL) supported by the surface comprising wire-shaped, conical, or tapered semiconductor elements (20), each semiconductor element (20) being mainly made of a III-V compound; and
an at least partially transparent first dielectric layer (34) covering the light-emitting diodes, **characterized in**

**that** the refractive index of the first dielectric layer is in the range from 1.6 to 1.8 and the maximum thickness of the first dielectric layer is in the range from 250 nm to 50 $\mu$m, the first dielectric layer covering each semiconductor element.

2. The optoelectronic device of claim 1, wherein the first dielectric layer (34) is an oxide formed by physical vapor deposition.

3. The optoelectronic device of claim 1 or 2, wherein the refractive index of the first dielectric layer (34) is in the range from 1.7 to 1.75.

4. The optoelectronic device of any of claims 1 to 3, wherein each semiconductor element (20) mainly comprises gallium nitride.

5. The optoelectronic device of any of claims 1 to 4, wherein the mean diameter of each semiconductor element (20) is in the range from 200 nm to 1 $\mu$m.

6. The optoelectronic device of any of claims 1 to 5, wherein the first dielectric layer (34) comprises a matrix made of a first at least partially transparent material having particles of a second material spread therein, the refractive index of the second material being greater than the refractive index of the first material.

7. The optoelectronic device of claim 6, wherein the first material is a polysiloxane.

8. The optoelectronic device of claim 6 or 7, wherein the second material is a dielectric material selected from among titanium oxide ($TiO_2$), zirconium oxide ($ZrO_2$), and zinc sulfide (ZnS) .

9. The optoelectronic device of any of claims 1 to 8, comprising an at least partially transparent second layer covering the first layer (84).

10. The optoelectronic device of claim 9, comprising a stack comprising an at least partially transparent third layer and the second layer, said stack covering the first layer (84).

11. The optoelectronic device of any of claims 1 to 10, wherein the first dielectric layer (34) is made of a material selected from the group comprising epoxide polymers, silicon oxides of $SiO_x$ type, where x is a real number greater than 0 and smaller than to 2, silicon oxides of $SiO_yN_z$ type, where y is a real number greater than 0 and smaller than or equal to 2 and z is greater than 0 and smaller than or equal to 0.57, and aluminum oxide ($Al_2O_3$).

12. The optoelectronic device of any of claims 1 to 11, wherein the light-emitting diodes (DEL) are distributed over a portion (51) of the surface (12) and the surface density of light-emitting diodes (DEL) on the portion decreases away from the edges (52) of said portion.

13. The optoelectronic device of any of claims 1 to 12, wherein the light-emitting diodes (DEL) are distributed over a portion (70; 76; 80; 84; 86; 88; 94; 96; 98) of the surface (12) and wherein the ratio of the perimeter of said portion to the surface area of said portion is greater than or equal to 4 for a unit surface area.

Fig 1

Fig 2

Fig 3

Fig 4

Fig 5

Fig 6

Fig 7

Fig 8

Fig 9

Fig 10

15

Fig 11

Fig 12

Fig 13

Fig 14

Fig 15

Fig 16

Fig 17

Fig 18

Fig 19

Fig 20

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1363005

- US 2013313583 A

**Littérature non-brevet citée dans la description**

- **JEN-HAU CHENG et al.** Atomic layer déposition enabled interconnect technology for vertical nanowire arrays. *Sensors and Actuators A: Physical,* Janvier 2011, vol. 165 (1), 107-114